Europäisches Patentamt

European Patent Office

Office européen des brevets

(11) Veröffentlichungsnummer: **0 391 138**
**A2**

# (12) EUROPÄISCHE PATENTANMELDUNG

(21) Anmeldenummer: 90105331.4

(22) Anmeldetag: 21.03.90

(51) Int. Cl.⁵: **H01J 31/12**

(30) Priorität: 07.04.89 DE 3911345

(43) Veröffentlichungstag der Anmeldung:
**10.10.90 Patentblatt 90/41**

(84) Benannte Vertragsstaaten:
**DE FR GB IT NL**

(71) Anmelder: **Nokia Unterhaltungselektronik
(Deutschland) GmbH
Östliche Karl-Friedrich-Strasse 132
D-7530 Pforzheim(DE)**

(72) Erfinder: **Bubeck, Gotthold
Lichtensteinweg 9
D-7311 Erkenbrechtsweiler(DE)**
Erfinder: **Leutz, Konrad, Dr.
Im Tiefentobel 34
D-7333 Ebersbach(DE)**
Erfinder: **Speh, Stefan
Bertholdstrasse 3
D-7900 Ulm-Gögglingen(DE)**
Erfinder: **Tischer, Kurt-Manfred
Gerhart-Hauptmann-Weg 4
D-7317 Wendlingen(DE)**

(54) **Kontaktierungsbauteil für eine flache Anzeigeeinrichtung.**

(57) Ein Kontaktierungsbauteil für eine flache Anzeigeeinrichtung verfügt über eine Glasplatte (35), auf der eine Struktur von Leiterbändchen (20) angeordnet ist. Die Leiterbändchen werden auf der Glasplatte durch eine Frittraupe (36) gehalten.

Ein derartiges Kontaktierungsbauteil baut sehr flach. Es kann z. B. als Durchführungs- oder Kontaktleiste eingesetzt werden. Dann üben die Leiterbänd- chen nicht nur die Funktion von Durchführungs- oder Kontaktierungsstiften aus, sondern zugleich die Funktion von Verbindungsdrähten zwischen derartigen Stiften oder zwischen solchen Stiften und Elektroden. Die Bändchen können sehr gut mit anderen entsprechenden Bändchen oder mit flachen Elektroden verschweißt werden.

EP 0 391 138 A2

FIG.7

## Kontaktierungsbauteil für eine flache Anzeigeeinrichtung

TECHNISCHES GEBIET

Die Erfindung betrifft ein Kontaktierungsbauteil für eine flache Anzeigeeinrichtung, also ein Bauteil, wie es verwendet wird, um entweder Kontakte zwischen von außen hereingeführten Zuleitungen und Elektrodenanschlüssen im Inneren der Anzeigeeinrichtung herzustellen oder um elektrische Baugruppen im Inneren der Anzeigeeinrichtung untereinander zu verbinden.

STAND DER TECHNIK

Aus DE 23 58 878 A1 (US 3,882,355) ist eine flache Anzeigeeinrichtung mit einer gläsernen Frontplatte und einer metallenen Wanne bekannt. Im Boden der Wanne sind in isolierten Durchführungen Durchführungsstifte vorhanden, die jeweils über einzelne lose Drähte mit Kontaktstiften in einem Kontaktverteiler verbunden sind. Von den Kontaktstiften führen dann ebenfalls jeweils einzelne Drähte zu verschiedenen Elektroden, die von einem keramischen Substrat getragen werden.

Beim Herstellen von Elektrodenkontakten besteht grundsätzlich der Wunsch, die Kontaktieranordnung so auszugestalten, daß der Kontaktiervorgang möglichst einfach ausführbar ist.

DARSTELLUNG DER ERFINDUNG

Das erfindungsgemäße Kontaktierungsbauteil für eine flache Anzeigeeinrichtung zeichnet sich durch einen isolierenden Träger aus, der eine Vielzahl bändchenförmiger metallischer Leiter trägt.

Ein derartiges Kontaktierungsbauteil ist in, verschiedener Hinsicht für den Einbau in flache Anzeigeeinrichtungen besonders geeignet. Ein erster Vorteil besteht darin, daß aufgrund der verwendeten bändchenförmigen metallischen Leiter das Kontaktierungsbauteil besonders flach ausgebildet werden kann, also in seiner Form an die Form einer flachen Anzeigeeinrichtung angepaßt ist. Ein weiterer Vorteil besteht darin, daß die flachen Bändchen dadurch, daß sie an mindestens einer Seite über den Haltebereich überstehen, nicht nur die Funktion einer Durchführungs- oder Kontaktierungsleiste wahrnehmen, sondern darüber hinaus zugleich die Funktion von Verbindungsdrähten zwischen einer solchen Leiste und Anschlußstellen übernehmen können. Ein dritter Vorteil geht dahin, daß die bändchenförmigen Leiter leicht durch einen Schweißvorgang, insbesondere mittels eines Lasers, mit anderen flachen Leitern in einer flachen Anzeigeeinrichtung verbunden werden können.

Es ist auf einfache Art und Weise möglich, die genannten bändchenförmigen metallischen Leiter in unterschiedlichen Ebenen anzuordnen, wobei es wiederum einfach möglich ist, unterschiedliche Verläufe der einzelnen Leiter in jeweils einer Ebene einzustellen. So ist es von besonderem Vorteil, Kontaktierungsbauteile einzusetzen, bei denen die Bändchen an einer Seite mit geringem gegenseitigem Abstand geführt sind, während sie an der anderen Seite einen erheblich größeren gegenseitigen Abstand aufweisen. Innerhalb des Haltebereichs sind die Leiterbahnen auseinandergeführt.

Ein erfindungsgemäßes Kontaktierungsbauteil kann aber auch so ausgebildet sein, daß die bändchenförmigen metallischen Leiter schraubenförmig verlaufen, damit jede Leiterbahn dann, wenn das Kontaktierungsbauteil auf eine regelmäßige Elektrodenstruktur aufgesetzt ist, z. B. nur jede fünfte Elektrode kontaktiert.

Abhängig von der Anwendung wird die Ausführung des Trägers gewählt. Soll der Träger z. B. an ebenen Halteflächen befestigt werden, ist es von Vorteil, eine ebene Trägerplatte zu verwenden, in die die Leiterbändchen eingepreßt sind oder auf die sie aufgefrittet sind. Das Bauteil mit der Frittbefestigung läßt sich bei niedrigerer Temperatur herstellen, während das Bauteil mit den eingepreßten Bändchen den Vorteil sehr geringer Bauhöhe aufweist. Wird das Kontaktierungsbauteil nicht an einer flachen Haltefläche befestigt, sondern wird es z. B. als Durchführungsbauteil in einen Schlitz eingefrittet, kann der Träger in einfachster Weise lediglich durch eine getemperte Frittraupe gebildet sein, über die die Leiterbändchen mit ihren Ebenen überstehen.

Zum Herstellen sehr billiger Kontaktierungsbauteile ist es von Vorteil, als Material für die Leiterbändchen unlegiertes Eisenblech zu verwenden. Dieses ist von den Materialkosten her günstiger als legiertes Eisenblech mit typischerweise etwa 50 % an Legierungsmetall, und die Bändchen lassen sich besonders einfach durch Ätzen herstellen. Vorzugsweise kommt Eisenblech mit einer Schutzschicht, insbesondere einer solchen aus Nickel, zur Anwendung.

KURZE BESCHREIBUNG DER FIGUREN

Fig. 1 schematische Draufsicht auf ein Kontaktierungsbauteil während eines Fertigungszwischenschrittes, mit durchgehend zueinander parallelen Leiterbändchen, die durch Sinterglas zusammengehalten werden;

Fig. 2 Querschnitt durch ein Kontaktierungsbauteil gemäß Fig. 1, mit Leiterbändchen in zwei Ebenen;

Fig. 3 Querschnitt durch den Durchführungsbereich einer flachen Anzeigeeinrichtung, mit einem Kontaktierungsbauteil mit Leiterbändchen in einer Ebene;

Fig. 4 Teillängsschnitt durch ein Kontaktierungsbauteil mit Leiterbändchen, die in eine Keramikplatte vor deren Tempern eingepreßt worden sind;

Fig. 5 Teillängsschnitt durch ein Kontaktierungsbauteil mit Leiterbändchen, die auf einer Glasplatte mit Hilfe einer Fritteschicht festgehalten werden;

Fig. 6 Teillängsschnitt durch ein Kontaktierungsbauteil, bei dem Leiterbändchen lediglich durch Frittmaterial gehalten werden, während des Herstellens und in endgültigem Zustand;

Fig. 7 Draufsicht auf ein Kontaktierungsbauteil mit einem Aufbau entsprechend dem von Fig. 5, bei dem jedoch die Leiterbändchen an der einen Seite einen größeren gegenseitigen Abstand aufweisen als an der anderen Seite;

Fig. 8 schematische perspektivische Ansicht eines Kontaktierungsbauteils, das zum Kontaktieren nur jeder dritten Elektrode einer regelmäßigen Elektrodenanordnung mit Hilfe jeweils eines einzelnen Leiterbändchens dient, bei welcher schematischen Darstellung der Übersichtlichkeit halber eine Frittraupe weggelassen ist, die die Bändchen hält;

Fig. 9 Teilseitenansicht des Bauteils gemäß Fig. 8;

Fig. 10 Querschnitt durch das Bauteil gemäß Fig. 9; und

Fig. 11 Draufsicht auf eine Leiterbändchenanordnung, die auf einen Träger aufgelegt ist, zum Herstellen des Bauteils gemäß den Fig. 8 - 10.

WEGE ZUM AUSFÜHREN DER ERFINDUNG

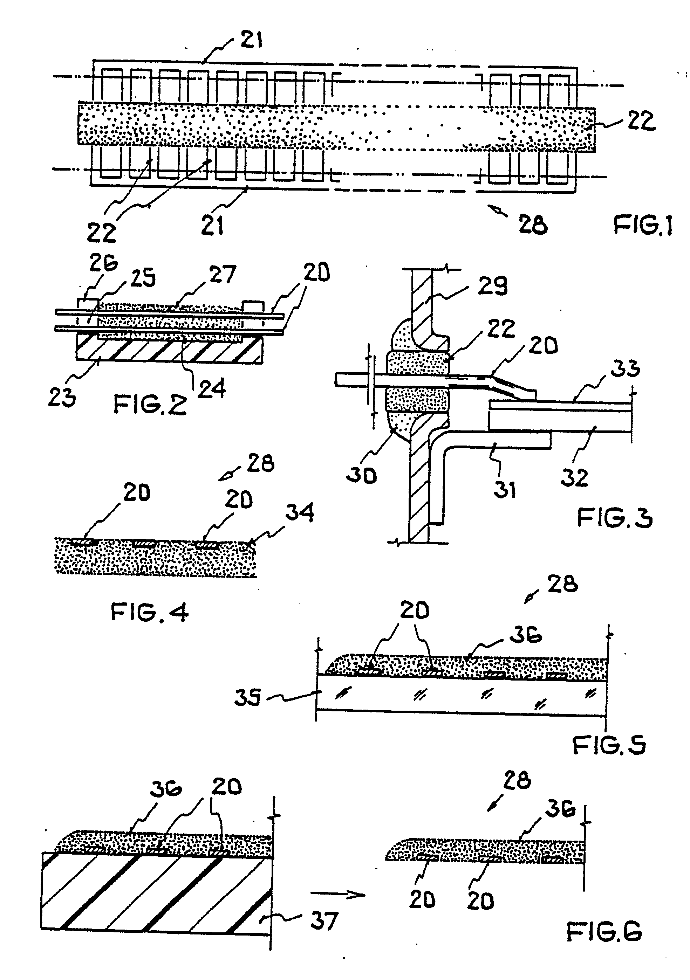

Das Kontaktierungsbauteil gemäß Fig. 1 ist in einem Fertigungszwischenschritt dargestellt, bei dem eine Vielzahl bändchenförmigermetallischer Leiter an ihren Enden noch durch Haltestreifen 21 miteinander verbunden sind. Die Leiterbändchen 20 mit den Haltestreifen 21 sind aus einer Metallplatte z. B. durch Ausstanzen oder Ätzen hergestellt, je nach Feinheit der gewünschten Struktur. Beim fertigen Bauteil sind die Haltestreifen 21 entlang der gestrichelten Linien abgetrennt. Damit in diesem Zustand die Leiterbändchen 20 noch zusammenhalten, sind sie durch einen Sinterglasstrang 22 gehalten. Dieser hält, was auf der Draufsicht gemäß Fig. 1 nicht erkennbar ist, zwei Ebenen von Leiterbändchen 20.

Der Sinterglasstrang 22 wird dadurch hergestellt, daß auf ein langgestrecktes Formunterteil 23 mit einem Mittenkanal 24 zunächst Leiterbändchen 20 mit Haltestreifen aufgelegt werden, wie dies aus Fig. 1 erkennbar ist. Es folgt dann ein Formmittenteil 25, das in der Mitte, über dem Mittenkanal 24, ausgebrochen ist. Es folgt eine zweite Leiterbändchenanordnung und schließlich ein Formoberteil 26, das entsprechend ausgebildet ist wie das Formmittenteil 25. Alle Formteile bestehen aus Kohle. In den Mittenkanal 24 und die darüber befindlichen freien Räume der Formteile ist ein Sinterglaspulver 27 eingefüllt. Diese Anordnung wird unter Schutzgas so weit erhitzt, daß das Sinterglaspulver 24 zusammenbackt. Wenn dieser Tempervorgang beendet ist, werden die Haltestreifen 21 abgetrennt. Dadurch ist ein Kontaktierungsbauteil mit zahlreichen Leiterbändchen 20 hergestellt, die in zwei unterschiedlichen Ebenen liegen.

In Fig. 3 ist dargestellt, wie ein solches Kontaktierungsbauteil 28, das jedoch Leiterbändchen 20 nur in einer Ebene aufweist, in einen Durchbruch in der Wanne 29 einer flachen Anzeigeeinrichtung eingesetzt ist. Der Durchbruch ist, was aus Fig. 3 nicht erkennbar ist, mindestens so lang wie der Sinterglasstrang 22. Dieser ist mit den durch ihn gehaltenen Leiterbändchen 20 in den langgestreckten Schlitz eingeschoben und dann in diesen Schlitz mit Hilfe einer Frittnaht 30 eingeschmolzen. An der Wanne 29 ist über einen Haltewinkel 31 eine Elektrodenträgerplatte 32 befestigt, die auf ihrer nach unten zeigenden Fläche eine Vielzahl nebeneinander liegender Elektroden trägt, von denen jedoch in der Ansicht gemäß Fig. 3 nur eine einzige Elektrode 33 erkennbar ist, da die Elektroden, wie auch die Leiterbändchen 20 in Blickrichtung in jeweils einer Ebene hintereinander liegen. Je ein Leiterbändchen 20 kontaktiert von unten eine Elektrode 33 und ist mit dieser mit Hilfe eines Laserstrahl-Schweißpunktes verbunden.

Es ist erkennbar, daß das Kontaktierungsbauteil 28 bei dieser Anordnung zugleich Durchführungs wie auch Verbindungsfunktion ausübt. Es sind nicht mehr Kontaktierungsdrähte zwischen Durchführungsstiften und Elektroden erforderlich, sondern die Leiterbändchen 20 sind zugleich Durchführung und Draht. Durch ihre Bändchenform lassen sie sich besonders leicht mit flachen Elektroden verschweißen, wie sie in flachen Anzeigeeinrichtungen verwendet werden.

Durch die Fig. 4 - 6 sind Varianten dafür dargestellt, wie Leiterbändchen durch einen Träger gehalten werden können.

Beim Ausführungsbeispiel gemäß Fig. 4 ist der Träger eine Platte aus einem keramischen Material, z. B. aus Steatit, Fosterit oder Cordierit. Diese Materialien sind vor dem Sintern noch so weich, daß Leiterbändchen 20 von einer Oberfläche her eingepreßt werden können. Nach dem Sintern halten die Bändchen fest in der Keramikplatte 34, da das Keramikmaterial während des Sinterns schrumpft und dadurch die Leiterbändchen 20 fest von drei Seiten einschließt.

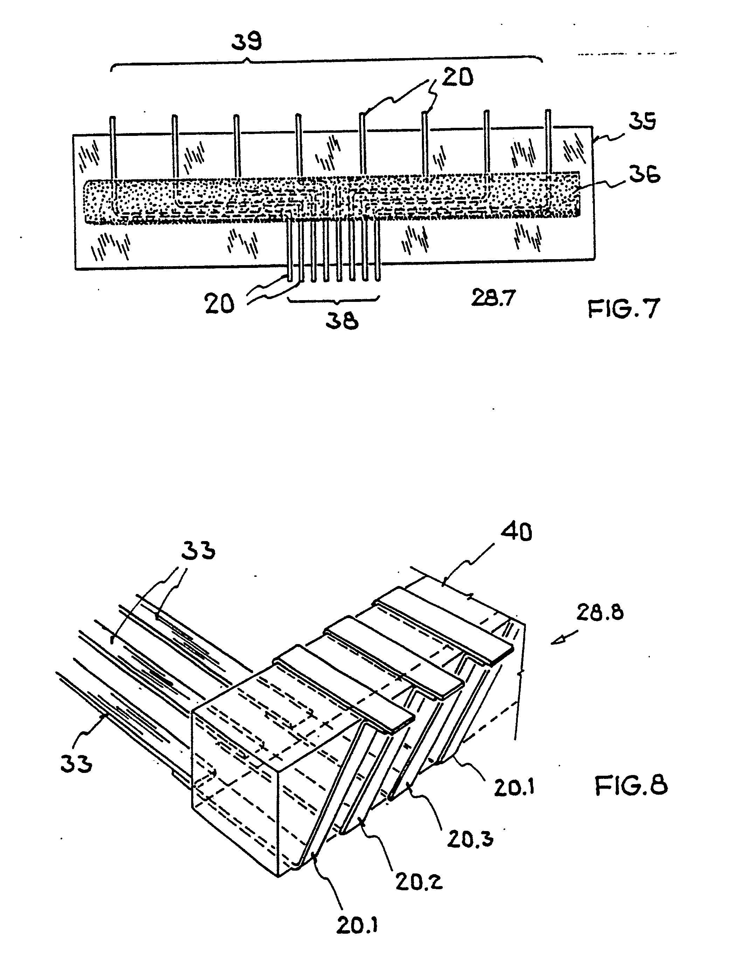

Bei der Ausführungsform gemäß Fig. 5 liegt eine Struktur mit Leiterbändchen 20 auf einer Glasplatte 35. Die Leiterbändchen sind mit der Glasplatte durch eine Frittraupe 36 verbunden. Bei diesem Ausführungsbeispiel besteht die Glasplatte 35 aus üblichem Floatglas, die Frittraupe besteht aus Fritte Nr. 8596 der Firma Schott und die Leiterbändchen 20 sind aus einem üblichen legierten Eisenblech geätzt, das etwa 50 % Legierungsanteil an Nickel enthält.

Bei der Ausführungsform gemäß Fig. 6 besteht das Kontaktierungsbauteil nur aus den Leiterbändchen 20 und einer Frittraupe 36. Eine Leiterbändchenstruktur mit Haltestreifen, wie in Fig. 1 dargestellt, wird auf einen Kohleträger 37 gelegt und dann wird über den mittleren Bereich der Leiterbändchen eine Frittraupe gezogen. Nach dem Trocknen der Frittraupe wird die Anordnung vom Kohleträger 37 abgehoben und gesintert.

Anhand von Fig. 7 soll veranschaulicht werden, daß Leiterbändchen 20 nicht alle parallel sein müssen, wie bei der Ausführungsform gemäß Fig. 1 dargestellt, sondern daß der Verlauf der Bändchen an die jeweilige Anwendung angepaßt werden kann. So dient das Kontaktierungsbauteil 28.7 gemäß Fig. 7 dazu, (nicht dargestellte) Elektroden zu kontaktieren, deren gegenseitiger Abstand größer ist als der Abstand, den Leitungen auf der Leitungszuführungsseite zueinander haben. Das Kontaktierungsbauteil 28.7 verfügt über 10 Leiterbändchen 20, deren gegenseitiger Abstand auf der Elektrodenanschlußseite 39 etwa das Fünffache des gegenseiteigen Abstands auf der Leitungszuführungsseite 38 ist. Das Bauteil ist entsprechend aufgebaut, wie das anhand von Fig. 5 erläuterte, also mit einer Glasplatte 35 und einer Frittraupe 36, die die Leiterbändchen 20 in einem Haltebereich abdeckt. Innerhalb dieses Haltebereichs, unter der Frittraupe 36, verlaufen die Leiterbändchen 20 so, daß sich ihr gegenseitiger Abstand aufspreizt, was durch gestrichelte Linien dargestellt ist.

Das Kontaktierungsbauteil 28.7 kann z. B. zusammen mit einem Durchführungsbauteil eingesetzt werden, wie es anhand von Fig. 3 beschrieben wurde. Es sei angenommen, daß für die Durchführung nur relativ wenig Raum zur Verfügung steht, weswegen in der Durchführung die Leiterbändchen 20 erheblich dichter aneinander liegen müssen, als es dem gegenseitigen Abstand der zu kontaktierenden Elektroden 33 entspricht. Dann werden die ins Innere der Anzeigeeinrichtung zeigenden Enden, der Leiterbändchen 20 nicht direkt mit den Elektroden 33 kontaktiert, sondern die genannten Enden der Leiterbändchen 20 kontaktieren zunächst die Leiterbändchen auf der Leitungszuführungsseite 38 des Kontaktierungsbauteils 28.7 und erst die Leiterbändchen auf der Elektrodenanschlußseite 39 kontaktieren die (in Fig. 7 nicht dargestellten) Elektroden 33.

Diese Anordnung sei mit der eingangs genannten Anordnung verglichen, wie sie aus DE 23 58 878 bekannt ist. Dort sind zwischen den Durchführungsstiften und den Kontaktstiften sowie den Kontaktstiften und den Elektroden jeweils Verbindungsdrähte erforderlich. Alle diese Verbindungsdrähte fallen bei der eben beschriebenen Anordnung weg. Dadurch ist nur noch die Hälfte an Schweißstellen erforderlich. Die Verschweißungen an diesen Stellen sind darüber hinaus außerordentlich einfach ausführbar, da die zu verbindenden Bändchen bzw. die zu verbindenden Bändchen und Elektroden genau zueinander justiert sind, so daß die beiden Reihen von Kontaktierungsbereichen einfach durch einen gepulsten Laserstrahl zum Herstellen von Schweißverbindungen abgerastert werden können.

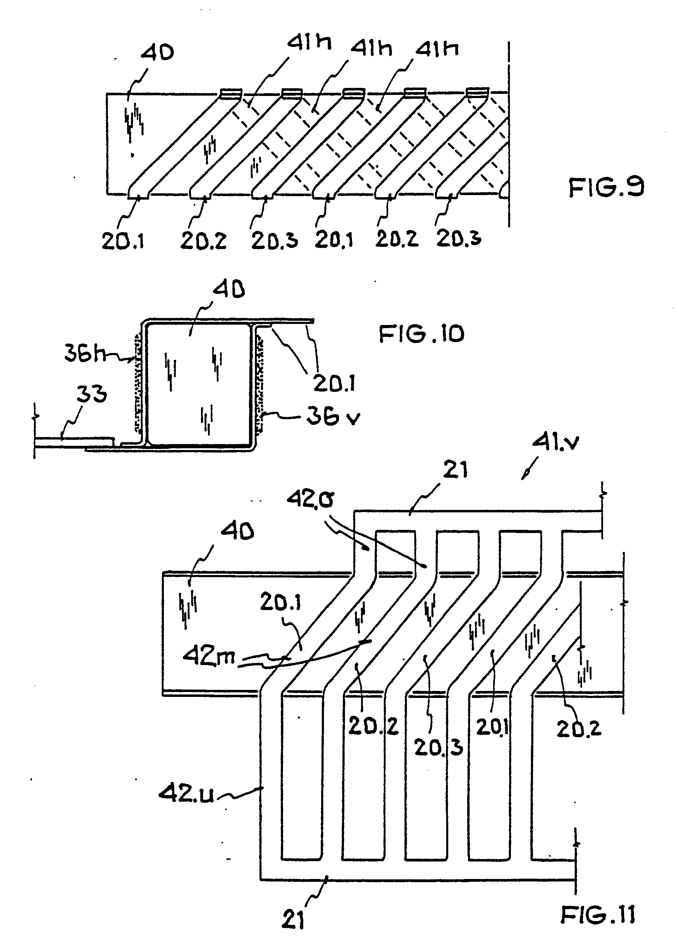

Das Kontaktierungsbauteil 28.8 gemäß Fig. 8 dient dazu, um mit jeweils einer einzigen von drei Leiterbändchenbahnen 20.1, 20.2 und 20.3 jeweils jede dritte Elektrode in einer regelmäßigen Anordnung zueinander paralleler streifenförmiger Elektroden 33 kontaktieren zu können. Bei der schematischen Darstellung gemäß Fig. 8 sind die Leiterbändchen als ununterbrochene Bahnen dargestellt, die schraubenförmig um einen quaderförmigen Träger 40 gewickelt sind. Es wird darauf hingewiesen, daß bei der dargestellten Anordnung zum besseren Veranschaulichen das Wickeln nicht genau schraubenförmig vorgenommen ist, sondern daß, wie dies aus den Fig. 8 und 9 erkennbar ist, alle Bändchen an der Ober- und Unterseite des quaderförmigen Trägers 40 rechtwinklig zur Längserstreckung des Trägers geführt sind, während sie auf der Vorder- und Rückseite schräg verlaufen. Dabei laufen alle Bändchen auf der Vorderseite von links unten nach rechts oben und auf der Rückseite von links oben nach rechts unten.

Tatsächlich sind nicht lange Leiterbändchen um den quaderförmigen Träger 40 gewickelt, sondern es liegen zwei Leiterbändchenanordnungen vor, nämlich eine vordere Leiterbändchenanordnung 41.v und eine hintere Leiterbändchenanordnung 41.h. In Fig. 11 ist die vordere Leiterbändchenanordnung 41.v dargestellt. In ihr verfügt jedes einzelne Leiterbändchen 20.1 über einen unteren, längeren Abschnitt 42.u und einen oberen, kürzeren Abschnitt 42.o, die beide rechtwinklig zur Längserstreckungsrichtung des Trägers 40 stehen. Die beiden Abschnitte werden jeweils durch einen mittleren Abschnitt 42.m verbunden, der von links unten nach rechts oben läuft. Dieser mittlere Abschnitt ist gerade so hoch wie der quaderförmige Träger 40. Er ist auf der Vorderseite des Trägers durch eine vordere Frittraupe 36.v befestigt. Entsprechend ist die hintere Leiterbändchenanordnung 41.h durch eine hintere Frittraupe 36.h mit der Rückseite des Trägers 40 verbunden.

Wie aus Fig. 10 erkennbar, ist jeder untere Abschnitt 42.u eines Leiterbändchens so nach hinten gebogen, daß er an der Unterseite des quaderförmigen Trägers anliegt. Jeder obere Abschnitt 42.u ist so nach vorne gebogen, daß seine obere Fläche in der Ebene der Oberfläche des quaderförmigen Trägers 40 liegt. Die hintere Leiterbändchenanordnung 41.h ist so ausgebildet, daß die oberen Abschnitte der Leiterbändchen länger sind als die unteren Abschnitte, die mittleren Abschnitte verlaufen bei der Ansicht gemäß Fig. 11 von links oben nach rechts unten, was allerdings der Übersichtlichkeit halber nicht dargestellt ist. Die oberen Abschnitte sind nach vorne gebogen und liegen auf der Oberseite des quaderförmigen Trägers 40 auf. Sie sind mit den oberen Abschnitten der Leiterbändchen aus der vorderen Leiterbändchenanordnung 41.v verschweißt. Außerdem erfolgt über diese Abschnitte die Zuführung von Signalen. Die Weitergabe der Signale an Elektroden 33 erfolgt über die nach hinten gebogenen unteren Abschnitte 42.u der Leiterbändchen 20.1, 20.2 und 20.3 der vorderen Leiterbändchenanordnung 41.v. Mit diesen Abschnitten sind die unteren, relativ kurz ausgebildeten Abschnitte der Leiterbändchen der hinteren Leiterbändchenanordnung 41.h verschweißt.

Das Kontaktierungsbauteil 28.8 gemäß den Fig. 8 - 11 wird dadurch hergestellt, daß der quaderförmige Träger 40 mit seiner hinteren Fläche nach unten auf eine Unterlage gelegt wird, daß dann die vordere Leiterbändchenanordnung 41.v in noch nicht gebogenem Zustand auf ihn gelegt wird, daß dann die Frittraupe 36.v aufgetragen und gesintert wird, daß dann die so gebildete Anordnung um 180° gedreht wird, die hintere Leiterbändchenanordnung 41.h aufgelegt wird und dann die hintere Frittraupe 36.h aufgetragen und gesintert wird. Anschließend werden die Bändchen in der beschriebenen Weise gebogen und miteinander verschweißt. Schließlich werden Haltestreifen 21 abgetrennt, über die die Enden der Bändchen der Stabilität halber bis dahin verbunden waren.

Auch beim Herstellen eines Kontaktierungsbauteiles 28 können die anhand der Fig. 2 und 4 - 6 erläuterten-Methoden, oder auch andere Methoden zum Verbinden metallischer Leiter mit einem isolierenden Träger, eingesetzt werden. Besonders einfach ist ein Verfahren gemäß Fig. 6. In diesem Fall werden Leiterbändchenanordnungen mit der Struktur gemäß Fig. 11 auf einen Kohleträger gelegt und mit einer Frittraupe im Bereich der mittleren Abschnitte 42.m überdeckt. Auf die Frittraupe wird eine zweite, gleich ausgebildete Leiterbändchenanordnung aufgedrückt, jedoch mit solcher Ausrichtung, daß die langen Abschnitte nun nach oben und die kurzen nach unten zeigen und die mittleren Bereiche statt von links unten nach rechts oben nun von links oben nach rechts unten verlaufen. Dann wird gesintert und abschließend werden die oben erläuterten Verformungs- und Kontaktierungsschritte vorgenommen.

Die Ausführungsbeispiele sollen veranschaulichen, daß Kontaktierungsbauteile mit einer Vielzahl von Leiterbändchen, die durch eine isolierenden Träger zusammengehalten werden, in vielerlei Ausführungsarten verwendet werden können und auf vielerlei Arten hergestellt werden können. Die im vorigen konkret angegebenen Materialien stellen nur wenige Beispiele für eine Vielzahl verwendbarer Materialien dar. Als Isolatoren können alle keramischen Materialien, Glasträger, Glaslote, Sinterglaspulver und Frittepulver verwendet werden, deren thermischer Ausdehnungskoeffizient nicht so stark von demjenigen der verwendeten Metalle abweicht, daß sich beim Herstellen oder im Betrieb Schwierigkeiten in bezug auf die Haltbarkeit des Bauteiles ergeben. Das Herstellen der Leiterbändchen kann auf beliebige Art und Weise, also insbesondere durch Stanzen oder durch Ätzen erfolgen. Vorzugsweise wird Eisenblech verwendet, das mit einer Schutzschicht versehen ist, z. B. das Material Hilumin von der Firma Hille & Müller. Dieses Material ist preiswert und läßt sich gut bearbeiten.

Bei allen Ausführungsbeispielen sind die Leiterbändchen mit solchen Längen dargestellt, daß sie über den jeweiligen isolierenden Träger überstehen. Dies ist jedoch nicht zwingend erforderlich. Zum Beispiel kann ein Kontaktierungsbauteil mit derartigen Bändchen als Zwischenkontaktstück zwischen anderen bändchenförmigen Leitern eingesetzt werden. Es sei angenommen, daß beim Bauteil gemäß Fig. 7 die Leiterbändchen 20 nicht über die Glasplatte 35 überstehen. Weiterhin sei angenommen, daß dieses Kontaktierungsbauteil zum Herstellen von Verbindungen zwischen ersten, eng benachbarten Kontaktstreifen und zweiten, weit beabstandeten Kontaktstreifen dient. Das wie beschrieben ausgebildete Kontaktierungsbauteil wird dann von unten so an die Kontaktbahnen gedrückt, daß die weit beabstandeten Leiterbändchenenden die weit beabstandeten Kontaktbahnen und die eng beabstandeten Leiterbändchenenden die eng beabstandeten Kontaktbahnen jeweils von unten berühren. Dann wird entlang der zwei Berührungsreihen ein getakteter Laserstrahl geführt, der an jeder Berührungsstelle die dortige Kontaktbahn mit dem darunter befindlichen Leiterbändchen verschweißt. Für viele Anwendungen ist es jedoch von Vorteil, die Leiterbändchen über den Träger überstehen zu lassen, damit sie in beiden Richtungen aus der Leiterbändchenebene heraus zum Heranführen an Kontaktstellen verbogen werden können und daß sie von beiden Seiten her verschweißt werden können.

**Ansprüche**

1. Kontaktierungsbauteil (28; 28.7, 28.8) für eine flache Anzeigeeinrichtung, **gekennzeichnet durch**
- eine Vielzahl bändchenförmiger metallischer Leiter (20; 20.1, 20.2, 20.3) und
- einen isolierenden Träger (22; 34; 35; 36; 40), der die Leiterbändchen hält.

2. Kontaktierungsbauteil nach Anspruch 1, **dadurch gekennzeichnet,** daß die Bändchen (20) alle in einer Ebene liegen.

3. Kontaktierungsbauteil nach Anspruch 1, **dadurch gekennzeichnet,** daß jeweils mehrere Bändchen (20) in einer jeweils gemeinsamen Ebene liegen.

4. Kontaktierungsbauteil nach Anspruch 1, **dadurch gekennzeichnet,** daß die Bändchen (20; 20.1, 20.2, 20.3) alle parallel zueinander verlaufen.

5. Kontaktierungsbauteil nach Anspruch 1, **dadurch gekennzeichnet,** daß die Bändchen (20.1, 20.2, 20.3) schraubenförmig angeordnet sind.

6. Kontaktierungsbauteil nach Anspruch 1, **dadurch gekennzeichnet,** daß die Bändchen in ihren Anfangsbereichen (38) mit ersten gegenseitigen Abständen parallel zueinander verlaufen, dann auseinanderlaufen und in ihren Endbereichen (39) mit größeren gegenseitigen Abständen ebenfalls parallel zueinander verlaufen.

7. Kontaktierungsbauteil nach Anspruch 1, **dadurch gekennzeichnet,** daß die Bändchen (20) durch eine getemperte Frittraupe (36; 36.v, 36.h) gehalten werden.

8. Kontaktierungsbauteil nach Anspruch 1, **dadurch gekennzeichnet,** daß die Bändchen (20) in einen isolierenden Träger (34) eingepreßt sind.

9. Kontaktierungsbauteil nach Anspruch 1, **dadurch gekennzeichnet,** daß die Bändchen (20) durch eine Trägerplatte (35) getragen werden und auf dieser durch ein Verbindungsmittel (36) gehalten werden, das in den Zwischenräumen zwischen den Bändchen an der Trägerplatte haftet.

10. Kontaktierungsbauteil nach Anspruch 1, **dadurch gekennzeichnet,** daß die Bändchen (20) aus unlegiertem Eisenblech mit einer Schutzschicht bestehen.

FIG.1

FIG.2

FIG.3

FIG.4

FIG.5

FIG.6

G. Bubeck 1-2-5-54
05.04.1989

FIG.7

FIG.8

G. Bubeck 1-2-5-54
05.04.1989

FIG.9

FIG.10

FIG.11

G. Bubeck 1-2-5-54
05.04.1989